# EUROPEAN PATENT APPLICATION

(11) **EP 4 836 594 A1**
(43) Date of publication of application: **04.11.2026**
(21) Application number: 25173488.5
(22) Date of filing: 30.04.2025
(51) Int. Cl.: H05K 1/02, H05K 3/00, H05K 1/03, H05K 1/14, H05K 3/28

(54) **PCB OVERMOLDING INTEGRATION WITH LEDS**

(71) Applicant: Covestro LLC, Pittsburgh, PA 15205-9741 (US)
(72) Inventor: Gresko, Jessica, Coraopolis, 15108 (US); Torgerson, Mark, Mars, 16046 (US)
(74) Representative: Levpat

(57) **Abstract**

Provided is a flexible printed circuit board comprising: a flexible printed circuit board (PCB) comprising: a rigid printed circuit board with a first edge having a first strip of design features overmolded thereon and a second edge located opposite the first edge and having a second strip of design features overmolded thereon, wherein the design features of the first strip and the design features of the second strip each independently comprise a two-dimensional shape selected from the group consisting of U-shapes, zigzag shapes, and Greek letter omega (W)-shapes, and wherein the rigid printed circuit board has one or more vias therein. The design features provide adhesion of the board to the thermoplastic resin and impart flexibility to the printed circuit board while reducing or eliminating warpage of the board.

## Description

### FIELD OF THE INVENTION

The present invention relates in general to electronic devices and more specifically to printed circuit boards overmolding integration with light emitting diodes.

Injection molding is a process of manufacturing parts by injecting molten material into a mold. Injection molding can be performed with thermoplastic and thermosetting polymers. The polymer material for the part is usually injected into a heated barrel, mixed (using a helical screw), and injected into a mold cavity, where the material cools and hardens to the configuration of the cavity. After a product is designed, molds are made by a mold-maker (or toolmaker), usually from either steel or aluminum, and precision-machined to form the features of the desired part. Injection molding can be employed for manufacturing a variety of parts, from the smallest components to entire body panels of cars.

Injection molding utilizes a special-purpose machine that has three components: an injection unit, a mold, and a clamp. Parts to be injection-molded must be very carefully designed to facilitate the molding process; the material used for the part, the desired shape and features of the part, the material of the mold, and the properties of the molding machine must all be considered. Two types of injection molding processes are insert molding and overmolding. The difference between insert molding and overmolding is that insert molding is performed with a pre-existing substrate (base or inner component).

Insert molding is a form of injection molding where a secondary part is formed over a substrate. A prefabricated part, often produced in a completely different facility or obtained from another company, is inserted into a mold, and then a secondary layer is formed around it. Insert molding is often used to add a plastic layer on top of a metal one, for example, to add a plastic handle to a metal screwdriver. Insert molding can be used to manufacture insulated pipes, wiring, and other similar products, or embed electronics into plastics.

Overmolding is a multi-step injection molding process in which two or more components are molded over top of one another. Overmolding is commonly referred to as "two-shot molding" because it is a two-step process. In a first step, a base component (substrate) is molded and cured. Such overmolded substrates are often made of plastic. In a second step, a second layer is molded directly on top of the first layer to create a single solid piece.

U.S. Pat. Pub. 2017/ 0787566 in the name of Prasannavenkatesan et al., discloses a multi-step molding process for manufacturing an electronic device chassis. The process is said to include at least two separate injection molding steps. During the first step, an electronic component is placed in a first mold, and a first material is injected into the first mold to create a first chassis that surrounds some of the electronic component. **In** the second step, the first chassis is placed in a second mold, and a second material is injected into the second mold to create a second chassis that surrounds some of the first chassis. The second step can be performed at a higher pressure than the first step, which is said to produce a smoother exterior surface. Furthermore, the first chassis shields the electronic component from the higher pressure of the second step, is said to reduce the likelihood of damage to the electronic component.

Jarisch et al., in EP3240099, teaches a method of manufacturing an electronic device in the form of an injection-molded part with a circuit board with electronic components, wherein the printed circuit board is inserted into the injection mold and at least from one side positively engage with a thermoplastic injection molding with electrical insulation properties and thermally well conducting properties and the thermoplastic injection molding material is molded with a BN and/or AIN particle filled polymer and an aesthetic appearance to the formation of the housing, and the circuit board in the region of the side surface structure and, in this way, the injection molding a molding material by means of insert molding has such a high bonding is achieved that when a heating of the electronic device in the region of the transition of the circuit board to the polymer in the form fit at least until 120 degrees centigrade, and a good heat dissipation is said to be ensured.

U.S. Pat. Pub. 2015/257278 in the name of Niskala et al., provides a method for manufacturing an electronic product, comprising providing a flexible, optionally optically substantially transparent or translucent, substrate film, printing a number of conductive traces of conductive ink on the substrate film, said traces defining a number of conductors and conductive contact areas for the contacts of at least one electronic surface-mountable component, disposing the at least one electronic surface-mountable component, such as an integrated circuit, on the substrate film so that the contacts meet the predefined contact areas when they are still wet to establish the electrical connection therebetween, and further securing, optionally overmolding, the component.

McMahon et al., in U.S. Pat. Pub. 2015/0108861 disclose encapsulated conformal electronic devices, encapsulated conformal integrated circuit (IC) sensor systems, and methods of making and using encapsulated conformal electronic devices. A conformal integrated circuit device is disclosed which includes a flexible substrate with electronic circuitry attached to the flexible substrate. A flexible encapsulation layer is attached to the flexible substrate. The flexible encapsulation layer encases the electronic circuitry between the flexible substrate and the encapsulation layer. For some configurations, the encapsulation layer and flexible substrate arc fabricated from stretchable and bendable non-conductive polymers. The electronic circuitry may comprise an integrated circuit sensor system with multiple device islands that are electrically and physically connected via a plurality of stretchable electrical interconnects.

To reduce or eliminate problems, therefore, a need exists in the art for a flexible, thermoplastic printed circuit board with reduced warpage.

Accordingly, the present invention reduces or eliminates problems inherent in the art by providing a flexible printed circuit board comprising a printed circuit board comprising a first edge having a first strip of design features overmolded thereon, and a second edge located opposite the first edge of the circuit board and having a second strip of design features overmolded thereon, wherein the design features comprise a two-dimensional shape selected from the group consisting of U-shapes, zigzag shapes, and Greek letter omega (W)-shapes. The design features help to provide adhesion of the board to the thermoplastic resin and impart flexibility to the printed circuit board while reducing or eliminating warpage of the board.

These and other advantages and benefits of the present invention will be apparent from the Detailed Description of the Invention herein below.

### BRIEF DESCRIPTION OF THE FIGURES

The present invention will now be described for purposes of illustration and not limitation in conjunction with the figures, wherein:
FIG. 1 provides a step-by-step diagram of the process according to the present invention;
FIG. 2 depicts the final stack-up;
FIG. 3 illustrates the first shot of the process according to the invention;
FIG. 4 illustrates the second shot of the process according to the invention;
FIG. 5 shows the first shot and the printed circuit board with two different textures, A and B;
FIG. 6 depicts the printed circuit board of FIG. 4 with Greek letter omega (W)-shape design features on opposite edges of the board;
FIG. 7 is a photograph showing the Greek letter omega (W)-shapes arranged in alternating inverted and non-inverted orientations overmolded along the edges of the printed circuit board of the invention;
FIG. 8 depicts some possible design features including U-shapes, zigzag-shapes, and omega-shapes;
FIG. 9 shows due the stiffness of the board, high warpage with first shot only;
FIG. 10 illustrates how the overmolding of the second shot decreases the warpage, however, there is still slight bow in the plaque;
FIG. 11 depicts an overmolded prototype part having two different textures and a row of LEDs along the side of the part where the Greek letter omega (W)-shape design features have been added by overmolding;
FIG. 12 illustrates an overmolded prototype part having two different textures and a row of LEDs and a row of Greek letter omega (W)-shape design features along opposite sides of the part;
FIG. 13A and FIG. 13B show warpage analysis for a standard FR4 printed circuit board with no design features;
FIG. 14A and FIG. 14B illustrate warpage analysis for Greek letter omega (W)-shape design feature printed circuit board with no pretension;
FIG. 15A and FIG. 15B depict warpage analysis for U-shape design feature printed circuit board with no pretension; and
FIG. 16A and FIG. 16B shows warpage analysis for a zigzag shape design feature printed circuit board with no pretension.

The present invention will now be described for purposes of illustration and not limitation. Except in the operating examples, or where otherwise indicated, all numbers expressing quantities, percentages, and so forth in the specification are to be understood as being modified in all instances by the term "about."

Any numerical range recited in this specification is intended to include all sub-ranges of the same numerical precision subsumed within the recited range. For example, a range of "1.0 to 10.0" is intended to include all sub-ranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited in this specification is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such sub-ranges would comply with the requirements of 35 U.S.C. §112(a), and 35 U.S.C. §132(a). The various embodiments disclosed and described in this specification can comprise, consist of, or consist essentially of the features and characteristics as variously described herein.

Any patent, publication, or other disclosure material identified herein is incorporated by reference into this specification in its entirety unless otherwise indicated, but only to the extent that the incorporated material does not conflict with existing definitions, statements, or other disclosure material expressly set forth in this specification. As such, and to the extent necessary, the express disclosure as set forth in this specification supersedes any conflicting material incorporated by reference herein. Any material, or portion thereof, that is said to be incorporated by reference into this specification, but which conflicts with existing definitions, statements, or other disclosure material set forth herein, is only incorporated to the extent that no conflict arises between that incorporated material and the existing disclosure material. Applicant reserves the right to amend this specification to expressly recite any subject matter, or portion thereof, incorporated by reference herein.

Reference throughout this specification to "various non-limiting embodiments," "certain embodiments," or the like, means that a particular feature or characteristic may be included in an embodiment. Thus, use of the phrase "in various non-limiting embodiments," "in certain embodiments," or the like, in this specification does not necessarily refer to a common embodiment and may refer to different embodiments. Further, the particular features or characteristics may be combined in any suitable manner in one or more embodiments. Thus, the particular features or characteristics illustrated or described in connection with various or certain embodiments may be combined, in whole or in part, with the features or characteristics of one or more other embodiments without limitation. Such modifications and variations are intended to be included within the scope of the present specification.

The grammatical articles "a", "an", and "the", as used herein, are intended to include "at least one" or "one or more", unless otherwise indicated, even if "at least one" or "one or more" is expressly used in certain instances. Thus, these articles are used in this specification to refer to one or more than one (i.e., to "at least one") of the grammatical objects of the article. By way of example, and without limitation, "a component" means one or more components, and thus, possibly, more than one component is contemplated and may be employed or used in an implementation of the described embodiments. Further, the use of a singular noun includes the plural, and the use of a plural noun includes the singular, unless the context of the usage requires otherwise.

In a first embodiment, the present invention is directed to a flexible printed circuit board (PCB) comprising: a rigid printed circuit board with a first edge having a first strip of design features overmolded thereon and a second edge located opposite the first edge and having a second strip of design features overmolded thereon, wherein the design features of the first strip and the design features of the second strip each independently comprise a two-dimensional shape selected from the group consisting of U-shapes, zigzag shapes, and Greek letter omega (W)-shapes, and wherein the rigid printed circuit board has one or more vias therein. The design features help to provide adhesion of the board to the thermoplastic resin and impart flexibility to the printed circuit board while reducing or eliminating warpage of the board.

### Component (a)

According to the invention, "polycarbonate" is to be understood as meaning both homopolycarbonates and copolycarbonates, in particular, polycarbonates. These polycarbonates may be linear or branched in known fashion. According to the invention, mixtures of polycarbonates may also be used.

A "polycarbonate" or a "polycarbonate material" is a thermoplastic material preferably comprising at least 50 wt.% polycarbonate, more preferably at least 60 wt.% polycarbonate, and even more preferably, at least 65 wt.% polycarbonate.

A portion of up to 80 mol%, preferably of 20 mol% to 50 mol%, of the carbonate groups in the polycarbonates used in accordance with the invention may be replaced by aromatic dicarboxylic ester groups. Polycarbonates of this kind, incorporating both acid radicals from the carbonic acid and acid radicals from aromatic dicarboxylic acids in the molecule chain, are referred to as "aromatic polyestercarbonates." In the context of the present invention, they are encompassed by the umbrella term of the thermoplastic aromatic polycarbonates. The replacement of the carbonate groups by aromatic dicarboxylic acid ester groups takes place essentially stoichiometrically and quantitatively, so that the molar ratio of the reaction partners can also be found in the finished polyestercarbonate. The incorporation of dicarboxylic acid ester groups can be statistical as well as in blocks.

In various embodiments, the thermoplastic polycarbonates, including the thermoplastic aromatic polyestercarbonates, have weight average molecular weights M_{w}, determined by gel permeation chromatography under use of CH₂Cl₂ as diluent, of from 10,000 g/mol to 35,000 g/mol, in certain embodiments, from 12,000 g/mol to 32,000 g/mol, in selected embodiments, from 15,000 g/ mol to 32,000 g/mol, and in particular embodiments, from 20,000 g/mol to 31,500 g/mol. The gel permeation chromatography is conducted under the following conditions: calibration with linear polycarbonate (made from bisphenol A and phosgene) of known molecular weight distribution, standards from PSS Polymer Standards Service GmbH, Germany, calibration according to method 2301-0257502-09D (from the year 2009 in German language) from Currenta GmbH & Co. OHG, Leverkusen. Diluent methylene chloride. Column combination from cross-linked styrenedivinylbenzene resin. Diameter of the analytical columns: 7.5 mm, length: 300 mm. Particle size of the column material: 3 µm to 20 µm. Concentration of the solutions: 0.2 wt.%. Flow rate: 1.0 ml/min, temperature of the solution: 30°C. Detection by means of a refractive index (RI)-detector.

Details regarding the preparation of polycarbonates are disclosed in many patent documents spanning approximately the last 60 years. Reference may be made here to Schnell, "Chemistry and Physics of Polycarbonates", Polymer Reviews, Volume 9, Interscience Publishers, New York, London, Sydney 1964, to D. Freitag, U. Grigo, P.R. Miiller, H. Nouvertné, BAYER AG, "Polycarbonates" in Encyclopedia of Polymer Science and Engineering, Volume 11, Second Edition, 1988, pages 648-718 and finally to U. Grigo, K. Kirchner and P.R. Miiller "Polycarbonate" [Polycarbonates] in Becker/Braun, Kunststoff-Handbuch [Plastics Handbook], volume 3/1, Polycarbonate, Polyacetale, Polyester, Celluloseester [Polycarbonates, Polyacetals, Polyesters, Cellulose Esters], Carl Hanser Verlag Munich, Vienna 1992, pages 117-299.

Various processes for the production of the polycarbonates which are useful in the present invention, including polyestercarbonates, are the interfacial process and the melt transesterification process (e.g., U.S. Pat. Nos. 5,097,002; 5,340,905; 5,717,057; 6,596,840; 6,740,730; and 7,071,284).

Aromatic polycarbonates are prepared, for example, by reaction of dihydroxyaryl compounds with carbonyl halides, preferably phosgene, and/or with aromatic dicarbonyl dihalides, preferably benzenedicarbonyl dihalides, by the interfacial process, optionally with use of chain terminators and optionally with use of trifunctional or more than trifunctional branching agents, wherein for the production of polyestercarbonates a portion of the carbonic acid derivatives is replaced with aromatic dicarboxylic acids or derivatives of dicarboxylic acids, namely according to the carbonate structure units in the aromatic polycarbonates by dicarboxylic acid ester structure units. Preparation via a melt polymerization process by reaction of dihydroxyaryl compounds with, for example, diphenyl carbonate is likewise possible.

Dihydroxyaryl compounds suitable for the preparation of polycarbonates are those of the formula (1)

HO-Z-OH (1),

wherein,
- Z: is an aromatic radical of 6 to 30 carbon atoms which may contain one or more aromatic rings, may be substituted, and may contain aliphatic, cycloaliphatic radicals, alkylaryl groups, or heteroatoms as bridging elements.

Preferably, Z in formula (1) is a radical of the formula (2), 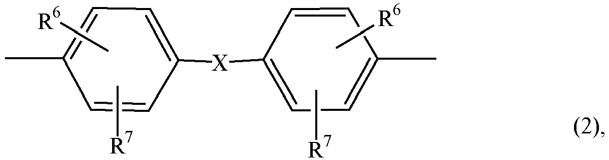 wherein
- R⁶ and R⁷: are each independently H, C₁-C₁₈-alkyl-, C₁-C₁₈-alkoxy, halogen such as Cl or Br or in each case optionally substituted aryl or aralkyl, in some embodiments H or C₁-C₁₂-alkyl, in certain embodiments H or C₁-C₈-alkyl and in selected embodiments H or methyl, and
- X: is a single bond, -SO₂-, -CO-, -O-, -S-, C₁-C₆-alkylene, C₂-C₅-alkylidene or C₅-C₆-cycloalkylidene which may be substituted by C₁-C₆-alkyl, preferably methyl or ethyl, or else C₆-C₁₂-arylene which may optionally be fused to further aromatic rings containing heteroatoms.

In various embodiments, X is a single bond, C₁-C₅-alkylene, C₂-C₅-alkylidene, C₅-C₆-cycloalkylidene, -O-, -SO-, -CO-, -S-, -SO₂- or a radical of the formula (2a),

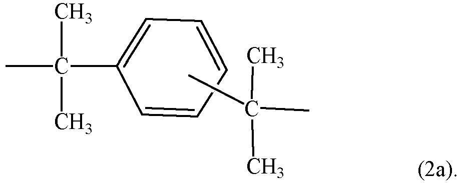

Examples of dihydroxyaryl compounds suitable for the preparation of the polycarbonates for use in accordance with the invention include, but are not limited to, hydroquinone, resorcinol, dihydroxydiphenyl, bis(hydroxyphenyl)alkanes, bis(hydroxyphenyl)cycloalkanes, bis(hydroxyphenyl) sulfides, bis(hydroxyphenyl) ethers, bis(hydroxyphenyl) ketones, bis(hydroxyphenyl) sulphones, bis(hydroxyphenyl) sulfoxides, a,a'-bis(hydroxyphenyl)diisopropylbenzenes and the alkylated, ring-alkylated and ring-halogenated compounds thereof.

Preferred dihydroxyaryl compounds are 4,4'-dihydroxydiphenyl, 2,2-bis(4-hydroxyphenyl)propane (bisphenol A), 2,4-bis(4-hydroxyphenyl)-2-methylbutane, dimethyl-bisphenol A, 1,1-bis(4-hydroxyphenyl)-p-diisopropylbenzene, 2,2-bis(3-methyl-4-hydroxyphenyl)propane, 2,2-bis(3-methyl-4-hydroxyphenyl)propane, bis(3,5-dimethyl-4-hydroxyphenyl)methane, 2,2-bis(3,5-dimethyl-4-hydroxyphenyl)propane, bis(3,5-dimethyl-4-hydroxyphenyl)sulfone, 2,4-bis(3,5-dimethyl-4-hydroxyphenyl)-2-methylbutane, 1,1-bis(3,5-dimethyl-4-hydroxyphenyl)-p-diisopropylbenzene and 1,1-bis(4-hydroxyphenyl)-3,3,5-trimethylcyclohexane, and bisphenols (I) to (III)

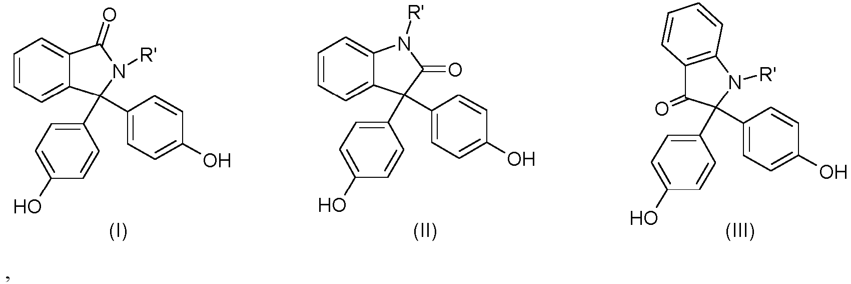

R' in each case is C₁-C₄-alkyl, aralkyl or aryl, in certain embodiments, methyl or phenyl, in selected embodiments, methyl.

In certain embodiments, the dihydroxyaryl compounds include 2,2-bis-(4-hydroxyphenyl)-propane (bisphenol A), 2,2-bis(3,5-dimethyl-4-hydroxyphenyl)propane, 1,1-bis(4-hydroxyphenyl)cyclohexane and 1,1-bis(4-hydroxyphenyl)-3,3,5-trimethylcyclohexane (bisphenol TMC) and dimethyl-bisphenol A as well as the dihydroxyaryl compounds of formulas (I), (II) and (III).

These and further suitable dihydroxyaryl compounds are described, for example, in U.S. Pat. Nos. 2,991,273; 2,999,835; 2,999,846; 3,148,172; 3,271,367; 4,982,014; DE 2 036 052 A, and DE 3 832 396 A; in French patent application 1 561 518 A1; GB1122003; GB1229482; GB1341318; GB1367790; in the monograph, H. Schnell, Chemistry and Physics of Polycarbonates, Interscience Publishers, New York 1964, p. 28 ff.; p.102 ff., and in D.G. Legrand, J.T. Bendler, Handbook of Polycarbonate Science and Technology, Marcel Dekker New York 2000, p. 72ff.

Only one dihydroxyaryl compound is used in the case of the homopolycarbonates; two or more dihydroxyaryl compounds are used in the case of copolycarbonates. The dihydroxyaryl compounds employed, as well as components of the compositions used in accordance with the invention, similarly to all other chemicals and assistants added to the synthesis, may be contaminated with the contaminants from their own synthesis, handling, and storage. However, it is desirable to employ the purest possible raw materials.

Examples of suitable carbonic acid derivatives include phosgene and diphenyl carbonate.

Suitable chain terminators useful in the production of polycarbonates are monophenols. Suitable monophenols include, for example, phenol itself, alkylphenols such as cresols, p-tert-butylphenol, cumylphenol, and mixtures thereof.

In various embodiments, chain terminators include phenols mono- or polysubstituted by linear or branched C₁-C₃₀-alkyl radicals, unsubstituted or substituted by tert-butyl. In selected embodiments, the chain terminators are phenol, cumylphenol and p-tert-butylphenol. The amount of chain terminator to be used may be 0.1 to 5 mol%, based on moles of dihydroxyaryl compounds used in each case. The chain terminators can be added before, during or after the reaction with a carbonic acid derivative.

Suitable branching agents include trifunctional or more than trifunctional compounds familiar in polycarbonate chemistry, particularly those having three or more than three phenolic OH groups. Examples of suitable branching agents include, but are not limited to, 1,3,5-tri(4-hydroxyphenyl)benzene, 1,1,1-tri(4-hydroxyphenyl)ethane, tri(4-hydroxyphenyl)phenylmethane, 2,4-bis(4-hydroxyphenylisopropyl)phenol, 2,6-bis(2-hydroxy-5'-methylbenzyl)-4-methylphenol, 2-(4-hydroxyphenyl)-2-(2,4-dihydroxyphenyl)propane, tetra(4-hydroxyphenyl)methane, tetra(4-(4-hydroxyphenylisopropyl)phenoxy)methane and 1,4-bis((4',4"-dihydroxytriphenyl)methyl)benzene and 3,3-bis(3-methyl-4-hydroxyphenyl)-2-oxo-2,3-dihydroindole. The amount of any branching agents to be used may be 0.05 mol% to 2 mol%, based on moles of dihydroxy aryl compounds used in each case. The branching agents can either be initially charged together with the dihydroxyaryl compounds and the chain terminators in the aqueous alkaline phase or added dissolved in an organic solvent before the phosgenation. In the case of the transesterification process, the branching agents are used together with the dihydroxyaryl compounds.

To facilitate incorporation of additives, component A may be used in the form of powders, pellets, or mixtures thereof.

In various embodiments, the polycarbonate has an MVR of from 4.5 to 34 cm³/(10 min), in certain embodiments of from 5.5 to 12 cm³/(10 min), in selected embodiments of from 6 to 10 cm³/(10 min), determined according to ISO 1133:2012-03 at a test temperature of 300 °C and 1.2 kg load.

A mixture of different polycarbonates may be used as component (a), for example a mixture of the polycarbonates a1 and a2, wherein a2 is a polycarbonate in powdered form. As used herein, the properties for the polycarbonate refer to a respective mixture.

In various embodiments, the compositions contain 50 wt.% to 98.5 wt.%, in some embodiments, 69.85 wt.% to 98.0 wt.%, in certain embodiments 85 wt.% to 97.5 wt.%, in selected embodiments 90.0 wt.% to 97.5 wt.%, and in particular embodiments, 93.0 wt.% to 97.5 wt.% of the aromatic polycarbonate.

### Component (b)

Component (b) of the polycarbonate comprises one or more stabilizers in the form of a polyether polyol. As those skilled in the art are aware, polyether polyols are the product of the polymerization of epoxides, such as ethylene oxide (EO), propylene oxide (PO), butylene oxide, styrene oxide, and epichlorohydrin, with themselves or by addition of such epoxides, optionally in admixture or sequentially, to starting components with reactive hydrogen atoms, such as water, alcohol, ammonia or amines. Such "starter molecules" usually have a functionality of from 1 to 6. Depending on the process control, such polyether polyols may be homopolymers, block copolymers, random copolymers, capped polymers, or polymers tipped with a mixture of different epoxides.

To specify such polyether polyols, various characteristics have become established in the art:
i) hydroxyl functionality, which depends on the starter molecule starting from which the polyether polyol is synthesized,
ii) hydroxyl or OH number, which is a measure of the content of hydroxyl groups stated in mg of KOH/g, determined according to DIN 53240-3:2016-03,
iii) where epoxides in which the ring opening causes the formation of different, i.e., primary or secondary) hydroxyl groups are used, on the one hand, the proportion of the respective epoxides in the polyether polyol is stated, and on the other hand, the proportion of primary or secondary hydroxyl groups based on the total number of hydroxyl groups present in the polyether polyol is stated, and
iv) the molecular weight (Mₙ or M_{w}), which is a measure of the length of the polyoxyalkylene chains of the polyether polyols.

In various embodiments, polyether polyols have a number average molecular weight Mₙ of from 100 to 6200 g/mol, in certain embodiments from 1500 to 4000 g/mol, and in selected embodiments from 1800 to 3000 g/mol, where. Mₙ is calculated according to the following formula: ${M}_{n} = 56100 * F / OHN ,$ where OH-number (OHN) is determined via hydroxyl end group titration according to DIN 53240-3:2016-03. OHN in mg KOH/g is inserted in the given formula. F is the functionality, which in the context of this invention is related to hydroxyl end groups. Acid end groups, if any, are not taken into account. F is defined as number of hydroxyl end groups, divided by the number of molecules in an ensemble, meaning F is the average number of hydroxyl end groups of a molecule of a compound. F is normally apparent from the recipe for preparing the polyol but may alternatively be determined by ¹H NMR.

In various embodiments, the polyether polyols may be formed from repeating ethylene oxide and propylene oxide units, e.g., with a share of 35 wt.% to 100 wt.% propylene oxide units, in certain embodiments 50 wt.% to 100 wt.% propylene oxide units. The copolymers may be statistical copolymers, gradient copolymers, alternating copolymers, or block copolymers formed from ethylene oxide and propylene oxide. In selected embodiments, the polyether polyols are linear polymers.

Useful polyether polyols are those formed from repeating propylene oxide units with a 1,2-diol as starter molecule, more preferably with propylene glycol as the starter molecule. The polyether polyols may be end-capped. In selected embodiments, the polyether polyol is end capped. A preferred agent for end-capping is dihydropyran (3,4-dihydro-2H-pyran).

In certain embodiments, the polyether polyols may be those formed from repeating propylene oxide units with propylene glycol as starter molecule, an OH number within a range of from 50 to 70 mg KOH/g determined according to DIN 53240-3:2016-03, and having a hydroxyl functionality of 2, a proportion of primary hydroxyl groups within a range of from 0 to 3%, based on the total number of primary and secondary hydroxyl groups, having a propylene oxide content of at least 95 wt.% and ethylene oxide content of up to 3 wt.%, in selected embodiments, those without any ethylene oxide units, but only with propylene oxide units.

The polycarbonates useful in the invention may comprise polyether polyols in various embodiments in an amount of from 0.1 to 5 wt.%, in certain embodiments, 0.1 wt.% to 2 wt.%, in selected embodiments, 0.5 wt.% to 1 wt.%, and in particular embodiments, 0.5 wt.% to 1.0 wt.%, wherein wt.% refers to the weight of the polycarbonate.

### Component (c)

The polycarbonates and polycarbonate blend compositions useful in the invention optionally may comprise additives known to those in the art as Component (c), including, but not limited to, flame retardants, antidripping agents, impact modifiers, fillers, antistats, coloring agents, pigments, thermal stabilizers different from Component (b), lubricants, demolding agents, UV absorbers, IR absorbers, hydrolysis stabilizers, and compatibilizers. Such additives as typically added in the case of polycarbonates are described, e.g., in U.S. Pat. Nos. 5,288,778; 5,821,380; and 5,883,165 and in "Plastics Additives Handbook", Hans Zweifel, 5th Edition 2000, Hanser Verlag, Munich.

The amount of such additives in various embodiments is up to 30 wt.%, in some embodiments up to 10 wt.%, in certain embodiments up to 6 wt.%, in selected embodiments 0.01 to 3 wt.%, and in particular embodiments 1 wt.%, with all values referring to the composition and all including the upper value.

Useful demolding agents include, but are not limited to, pentaerythrityl tetrastearate (PETS), glycerine monostearate (GMS), their carbonates, and mixtures of any of these.

Optionally, the composition may include a UV absorber. Various UV absorbers are those having as low a transmission as possible below 400 nm and as high a transmission as possible above 400 nm. Such UV absorbers are known in the art and described, e.g., in U.S. Pat. Nos. 5,288,778; 5,821,380; and 5,883,165. Ultraviolet absorbers particularly suitable for use in the composition according to the invention are selected from benzotriazoles, triazines, benzophenones, and arylated cyanoacrylates.

Particularly suitable ultraviolet absorbers are hydroxybenzotriazoles, such as 2-(3',5'-bis(1,1-dimethylbenzyl)-2'-hydroxyphenyl)benzotriazole (TINUVIN 234, BASF), 2-(2'-hydroxy-5'-(tert-octyl)phenyl)benzotriazole (TINUVIN 329, BASF), bis(3-(2H-benzotriazolyl)-2-hydroxy-5-tert-octyl)methane (TINUVIN 360, BASF), 2-(4,6-diphenyl-1,3,5-triazin-2-yl)-5-(hexyloxy)phenol (TINUVIN 1577, BASF), and also benzophenones such as 2,4-dihydroxybenzophenone (CHIMASSORB 22, BASF) and 2-hydroxy-4-(octyloxy)benzophenone (CHIMASSORB 81, BASF), 2,2-bis[[(2-cyano-1-oxo-3,3-diphenyl-2-propenyl)oxy]methyl]-1,3-propanediyl ester (9CI) (UVINUL 3030, BASF AG), 2-[2-hydroxy-4-(2-ethylhexyl)oxy]phenyl-4,6-di(4-phenyl)phenyl-1,3,5-triazine (TINUVIN 1600, BASF), tetraethyl-2,2'-(1,4-phenylenedimethylidene) bismalonate (HOSTAVIN B-Cap, Clariant) or N-(2-ethoxyphenyl)-N'-(2-ethylphenyl)ethanediamide (TINUVIN 312, CAS No. 23949-66-8, BASF). Particularly preferred specific UV absorbers are TINUVIN 360, TINUVIN 329 and/or TINUVIN 312, very particular preference being given to TINUVIN 329 and TINUVIN 312. It is also possible to employ mixtures of these ultraviolet absorbers.

Suitable IR absorbers are described, in a variety of patents including U.S. Pat. Nos. 7,074,351; 7,169,834; 8,153,239; and in U.S. Pat. Pub. 2005/0165148. Of those mentioned in the literature, boride- and/or tungstate-based IR absorbers, in particular, cesium tungstate or zinc-doped cesium tungstate, as well as ITO- or ATO-based IR absorbers and combinations thereof are particularly useful.

Suitable impact modifiers are core-shell type impact modifiers, including, but not limited to, acrylonitrile butadiene styrene (ABS), copolymer of methyl methacrylate, acrylonitrile, butadiene, and styrene (MBS), acryl-based, silicone-acryl-based impact modifiers, and non-core-shell type impact modifiers.

The polycarbonates and polycarbonate blends useful according to the invention may comprise organic and inorganic fillers in the usual amounts. Suitable fillers include, but are not limited to, glass fibers and carbon fibers, cellulosics, graphite, graphene, and carbon nanotubes, chalk, quartz powder, titanium dioxide, silicates, aluminosilicates, e.g., talc, wollastonite, montmorillonite, also modified by ion exchange, kaolin, zeolite, vermiculite, aluminum oxide, and silica. Mixtures of these or these and other fillers may also be used.

Polytetrafluoroethylene (PTFE) is a preferred antidripping agent, although other antidripping agents may be used.

Sulfur-containing stabilizers may be used including, but not limited to, 3,3'-thiodipropionic, distearyl disulfide (HOSTANOX SE 10, Clariant), pentaerythrityl tetrakis(3-laurylthiopropionate) (SOGNOX 4120, Songwon International AG) and bis-(phenylsulfonyl)methane.

The polymer compositions useful in the invention, comprising Components (a), (b), and optionally (c), are produced by standard incorporation processes via combination, mixing and homogenization of the individual constituents, especially with the homogenization taking place in the melt under the action of shear forces. If appropriate, combination and mixing prior to the melt homogenization occurs using powder premixes. For all components used, it is desirable to employ the purest possible compounds.

Various embodiments may use premixes of granules or granules and powders with Components (b) and optionally (c). Other embodiments may use premixes which have been produced from solutions of the mixture components in suitable solvents, in which case homogenization is optionally effected in solution and the solvent is removed. It is also possible to introduce Components (b) and optionally (c) into the polycarbonate by known methods or as a masterbatch. Masterbatches may be used in selected embodiments for incorporation of Component (c).

In this context, the composition useful in the invention may be combined, mixed, homogenized and subsequently extruded in customary apparatus such as screw extruders (TSE twin-screw extruders for example), kneaders or BRABENDER or BANBURY mills. In these embodiments, the extrudate may be cooled and comminuted after extrusion. It is also possible to premix individual components and to add the remaining starting materials individually and/or likewise in a mixture.

It is possible in various embodiments to combine and mix a premix in the melt in the plastifying unit of an injection-molding machine. In these embodiments, the melt is converted directly to a shaped body in the subsequent step.

The manufacture of the molded parts from the compositions according to the invention in various embodiments may be accomplished by injection-molding, extrusion, or rapid-heat cycle molding.

In various embodiments, the polycarbonate comprises a blend of a polycarbonate with acrylonitrile-styrene-butadiene (ABS).

A rubber-modified vinyl (co) polymer is included in polycarbonate/ABS blends,

B. l) 80 wt.% to 95 wt.%, preferably 83 wt.% to 93 wt.%, more preferably 85 wt.% to 92 wt.%, based on the rubber-modified vinyl (co) polymer B, structural units derived from at least one vinyl monomer and

B.2) 5 wt.% to 20 wt.%, preferably 7 wt.% to 17 wt.%, more preferably 8 wt.% to 15 wt.%, based on the rubber-modified vinyl (co) polymer B, one or more rubber-elastic graft bases having glass transition temperatures Tg< -50°C, preferably from < -60°C, particularly preferably < -70°C containing at least 50 wt .%, preferably at least 70 wt.%, particularly preferably 100 wt.%, based on B.2, derived from 1,3-butadiene structural units,
wherein the rubber-modified vinyl (co) polymer B is
   (i) a disperse phase consisting of
      (i. 1) with vinyl (co) polymer of structural units according to B.1 grafted rubber particles and
      (i.2) vinyl (co)polymer enclosed in the rubber particles as a separated disperse phase also from structural units according to B.1
      and
   (ii) a rubber-free vinyl (co)polymer matrix not bound to the rubber particles and not enclosed in these rubber particles consisting of structural units according to B.1,
and wherein the disperse phase according to (I) has an average diameter D50 measured by ultracentrifugation of 0.7 to 2.0 pm, preferably from 0.7 to 1.5 pm, in particular from 0.7 to 1.2 pm.

The glass transition temperature Tg is determined, unless expressly described otherwise in the present invention, for all components by means of differential scanning calorimetry (DSC) according to DIN EN 61006 (version of 1994) at a heating rate of 10 K / min with determination of the Tg as the center temperature (tangent method).

The rubber-modified vinyl (co) polymers according to component B have a melt flow rate (MVR), measured according to ISO 1133 (version of 2012) at 220 ° C with a stamp load of 10 kg, of preferably 2 to 20 ml/10min, more preferably 3 to 15 ml/10min, in particular 4 to 8 ml/10min. If mixtures of several rubber-modified vinyl (co)polymers are used as component B, the preferred MVR ranges are the mean value of the MVR of the individual components weighted over the mass fractions of the components in the mixture.

Such rubber-modified vinyl (co) polymers B are prepared, for example, by radical polymerization, preferably in the mass polymerization process, of
B.1 80 to 95 wt.%, preferably 83 to 93 wt.%, particularly preferably 85 to 92 wt.%, based on the rubber-modified vinyl (co) polymer B, at least one vinyl monomer in the presence of
B.2 5 to 20 wt.%, preferably 7 to 17 wt.%, particularly preferably 8 to 15 wt.%, based on the rubber-modified vinyl (co) polymer B, one or more rubber-elastic graft bases with glass transition temperatures < -50 ° C, preferably < -60 ° C, particularly preferably < -70 ° C, containing at least 50 wt .-%, preferably at least 70 wt.%, particularly preferably 100 wt.% based on B.2, of structural units derived from 1,3-butadiene.

In the mass polymerization process used for the preparation of the rubber-modified vinyl (co) polymer B, both the polymerization of the vinyl monomers according to B. 1 and a grafting of the resulting vinyl (co) polymer onto the rubber-elastic graft base according to B.2. Furthermore, in this reaction formation by self-organization (phase separation) the formation of a disperse phase (i) consisting of
(1.1) rubber particles grafted with vinyl(co)polymer from structural units according to B.l and
(1.2) vinyl (co)polymer enclosed in the rubber particles as a separate disperse phase also from structural units according to B.1,
wherein this rubber-containing phase (i) is dispersed in a rubber-free vinyl (co) polymer matrix (ii) consisting of structural units according to B. l not bound to the rubber particles and not enclosed in these rubber particles.

The rubber-free vinyl (co) polymer (ii) can be dissolved in contrast to the other vinyl (co) polymer proportions in component B by suitable solvents such as acetone.

The size of the disperse phase (i) in the rubber-modified vinyl (co) polymers B thus prepared is adjusted via the conditions of reaction formation such as temperature and resulting viscosity of the polymer and shear by, for example, stirring.

The average particle size D₅₀ is the diameter above and below which 50 wt.% of the particles lie. It is, unless expressly described otherwise in the present invention, for all components by means of ultracentrifuge measurement (W. Scholtan, H. Lange, Colloid and Polymer Science, 250 (1972), 782-796).

The monomers B.1 are preferably mixtures consisting of
B.1.1 60 to 85 wt. preferably, 65 to 80 wt., more preferably, 70 to 78 wt., parts, each based on the sum of B.1.1 and B.1.2, styrene and
B.1.2 15 to 40 wt. - preferably 20 to 35 wt., more preferably 22 to 30 wt. -Parts, each based on the sum of B.1.1 and B.1.2, acrylonitrile, and optionally,
B.1.3 0-10 wt., preferably 0-7 wt., more preferably 0-5 wt. -Parts methyl methacrylate or n-butyl acrylate, each based on 100 wt. -Parts as the sum of B.1.1 and B.l.2.

Preferred graft bases B.2 are diene rubbers containing butadiene, or mixtures of diene rubbers containing butadiene or copolymers of diene rubbers containing butadiene or mixtures thereof with other copolymerizable monomers (e.g., according to B.1.1 and B.1.2). Particularly preferred graft bases B.2 are produced by anionic polymeriziation using a lithium compound as polymerization catalyst. Particularly preferred as graft base B.2 is pure polybutadiene rubber. In a further preferred embodiment, B.2 is styrene-butadiene-block copolymer rubber.

Component B preferably has a polybutadiene content of 5 wt.% to 18 wt.%, more preferably from 7 wt.% to 15 wt.%, in particular from 8 wt.% to 13 wt.%.

Particularly preferred rubber-modified vinyl (co) polymers according to component B are mass ABS polymers such as those described for example in U.S. Pat. No. 3,644,574 (=DE-OS 2,035,390) or in DE-OS 2,248,242 (= GB-PS 1,409,275) or in Ullmann's Encyclopedia of Chemical Technology, Vol. 19 (1980), p. 280 ff. are described.

The not chemically bound to the rubber base (s) B.2 and not enclosed in the rubber particles vinyl (co) polymer (ii) can be formed as shown above due to the production during the polymerization of graft polymers B. It is also possible that some of this not chemically bound to the rubber base (s) B.2 and not included in the rubber particles vinyl (co) polymer (ii) in the rubber-modified vinyl (co) polymer according to component B is formed due to production during its production in the mass polymerization process and another part is polymerized separately and added to component B as portion of component B. The proportion of vinyl (co) polymer (ii), regardless of its origin, measured as an acetone-soluble portion, is in component B, based on component B, preferably at least 50 wt.%, particularly preferably at least 60 wt.%, more preferably at least 70 wt.%.

This vinyl (co) polymer (ii) has in the rubber-modified vinyl (co) polymers according to component B a weight-averaged molecular weight M_{w} from 70 to 250 kg / mol, preferably from 130 to 200 kg / mol, in particular from 150 to 180 kg / mol.

The weight-averaged molecular weight M_{w} of vinyl (co) polymer (ii) in component B is measured in the present invention by gel permeation chromatography (GPC) in tetrahydrofuran against a polystyrene standard.

Component B is preferably free of emulsifiers that are typically used in emulsion polymerization processes such as for example saturated fatty acids having 8 to 22 carbon atoms, resin acids, alkyl and alkylarylsulfonic acids, and fatty alcohol sulfates. Component B preferably contains less than 100 ppm, more preferably less than 50 ppm, most preferably less than 20 ppm ions of alkali metals and alkaline earth metals. Component B preferably contains an amount greater than zero but less than 10 ppm, more preferably 0.01 ppm-5 ppm, most preferably 0.1 ppm-2 ppm of lithium.

Suitable as component B rubber-modified vinyl (co) polymers are, for example, MAGNUM 3404, MAGNUM 3504, and MAGNUM 3904 from Trinseo S.A. (Luxembourg).

The compositions according to the present invention are suited for processing by the RIM process. In general, in the RIM process, two separate streams are intimately mixed and subsequently injected into a suitable mold, although it is possible to use more than two streams. In the known RIM process used for conducting the process according to the present invention, the components may be mixed simultaneously, or the non-reactive components may be pre-mixed and then mixed with the reactive components. A starting temperature of from 10°C to 70°C, preferably from 30°C to 50°C is chosen for the mixture introduced into the mold. The temperature of the mold itself is preferably from 40°C to 100°C, more preferably from 50°C to 70°C. After completion of the reaction and molding process, the resultant product is removed from the mold.

Rigid printed circuit boards have not been commonly used in insert molding with clear/translucent materials due to clear/translucent materials shrinking too much during processing whereas the FR4 boards do not. This shrinking in turn, causes warpage. The design of the inventive flexible circuit board minimizes warpage. Other applications encapsulating an FR4 circuit board into an injection-molded part use glass or mineral filled resins as the fillers, reducing the amount that the molded part shrinks after molding in those cases. The inventive use of clear (unfilled) resins is new.

Rigid printed circuit boards are advantageous for several reasons: cutting printed circuit boards to size, even with elaborate designs, is inexpensive and quick. High-speed routers and drilling equipment have been used to cut FR4and similar substrates for years and the shape can be cut in three to five seconds, even if it is complicated.

It is critical to have vias in a printed circuit board for overmolding because one can simply solder a standard connector to the side of the part that is not molded over and the LEDs on the side that is overmolded. Thus, long-standing problems with silver ink circuits is immediately solved by using rigid printed circuit boards.

Exemplary rigid printed circuit boards include metal core printed circuit boards, as well as printed circuit boards formed of laminates and dielectric materials, such as polytetrafluoroethylene (TEFLON), FR-2 (phenolic cotton paper), FR-3 (cotton paper and epoxy), FR-4 (woven glass and epoxy), FR-5 (woven glass and epoxy), FR-6 (matte glass and polyester), G-10 (woven glass and epoxy), CEM-1 (cotton paper and epoxy), CEM-2 (cotton paper and epoxy), CEM-3 (non-woven glass and epoxy), CEM-4 (woven glass and epoxy), and CEM-5 (woven glass and polyester). Preferred rigid printed circuit boards include metal core boards and FR-4 (woven glass and epoxy) boards.

The electronics/electrical component may be selected from among light emitting diodes (LEDs), resistors, constant current drivers, drivers/controllers, capacitors, microprocessors, integrated circuits, photocells, piezo-transducers, inductors, and proximity switches.

The openings in the electronic/electrical component may be standard openings, such as attachment openings (e.g., screw holes), through holes, vias (e.g., through-hole vias, blind vias, buried vias, microvias, and stacked microvias), or any combination thereof.

As those skilled in the art are aware, there are two types of film circuits - printed silver ink as the conductor or laminated copper foil that is etched as the conductor: silver ink on films made of polyethylene terephthalate is typical, whereas silver ink on films made of polycarbonate is rare. Drawbacks to using silver ink include that it is ten times or more the price of bulk silver and difficulty finding someone willing to process silver inks. The price of silver alone can be several dollars per circuit board. Silver inks are delicate, and the circuit is easily broken during transport of the films. Silver inks can be oxidized during their lifetime if any silver is exposed to air/heat. In addition, thin silver ink cannot be connected from the top surface to the bottom surface easily with a plated "via" as used in a standard printed circuit board and, therefore, bringing the electricity to the injection-molded/film interface is difficult or impossible to do reliably. State of the art methods require fragile film inserts and/or significant manual operations to hand-route wires bonded with conductive epoxy to a connector. Any attempt to use an eyelet or other mechanical clasping to join top circuits to bottom circuits typically causes the eyelet to function as a die-cutter. When 7000psi of injection molding force is applied to the film, the eyelet simply punches a hole in the film and breaks the circuit.

Polyethylene terephthalate (PET) films do not easily bond to polycarbonate resin in the film-insert molding process so special adhesion promotors or adhesives must be applied to the film before further processing and therefore increases costs due to additional materials and manufacturing steps. Applying LEDs or other electronic components to the polyethylene terephthalate film/silver ink circuit requires expensive silver paste adhesives instead of solder and few circuit board manufactures with the surface-mount technology (SMT) component placement systems, referred to as "pick-and-place machines" are willing to handle the film substrates and invest in silver ink dispensers rather than solder paste. Polyethylene terephthalate film substrates tend to roll up or even blow away (0.1mm or more) when in the pick-n-place machine that sets the components in place.

Copper foil on film: The only film that can withstand the etching process and soldering is polyimide which is completely incompatible with polycarbonate for the film-insert-molding process due to a lack of adhesion and wrinkling. Any eyelets used to bring electricity from top to bottom surface function as die-cutters when 7000 psi of resin is pressed on top of it. In addition, copper foil is difficult to handle, and a limited number of companies are willing to mount components to polyimide substrates.

Vias are the standard method to route electricity from top of board to bottom of the board. Rigid circuit boards of eight layers of copper and routing to all or some layers are common - and inexpensive - even though the complexities of 3D routings of power and signals may not be visible. A via is a hole which is filled with copper that moves current to a new layer of conductors in the circuit board. Plated hole vias are not reliable or economical with silver inks on flexible circuits. Vias can also be small pins of copper or brass - but film circuits are too thin to reliably hold a pin-type via. Also, films are not filled with glass or mineral so they move significantly with temperature and the pin-via can fall out when the film is warmed. Common rigid printed circuit boards are glass filled to maximize dimensional stability during temperature cycles.

The design features of the instant invention are thin, flexible plastic strips comprising polycarbonate that are overmolded preferably onto the opposite edges of the rigid printed circuit board and impart flexibility to the rigid board. Design features in the instant invention include, but are not limited to, two-dimensional shapes selected from the group consisting of U-shapes, zigzag shapes, and Greek letter omega (Ω)-shapes.

Texture may be embedded in the polycarbonate substrate. This may be accomplished by etching the texture into a steel mold surface. The polycarbonate replicates the surface texture during the injection molding process of the board. In most cases, the textures are decorative/branding type lighting effects which may be illuminated by LEDs from the edge of the board. It also may be possible to use so-called "top firing" LEDs to create a different type of ambient light, branding (logo) light or even a utility light, which are typically higher powered. Additionally, non-LED components can be used on the printed circuit board (resistors-as already are on the board) and microcontrollers, sensors and the like (so-called active and passive components). It should be noted that the texture is not a critical feature of the inventive rigid printed circuit board.

### EXAMPLES

The non-limiting and non-exhaustive examples that follow are intended to further describe various non-limiting and non-exhaustive embodiments without restricting the scope of the embodiments described in this specification. All quantities given in "parts" and "percents" are understood to be by weight, unless otherwise indicated.

The data provided in Table I was generated by utilizing an INSTRON tensile machine. The bottom of the board was clamped and held rigid. The top of the board was clamped and pulled upward to stretch the board. For the table you can shorten it by stating sample C1, omega1 (small), omega1 (large).

**Table I**

| **Sample** | **F (kN)** | **Displacement (mm)** | **Tensile strength (MPa)** |
|---|---|---|---|
| C1 | 1.04 | 2.02 | 64.9 |
| C2 | 0.98 | 1.85 | 61.5 |
| C3 | 1.25 | 2.08 | 78.3 |
| W1 (small) | 0.07 | 11.3 | 4.5 |
| W2 (small) | 0.07 | 12.75 | 4.6 |
| W3 (small) | 0.07 | 12.13 | 4.4 |
| W1 (large) | 0.07 | 11.24 | 4.2 |
| W2 (large) | 0.07 | 11.14 | 4.5 |
| W3 (large) | 0.07 | 10.82 | 4.4 |

Incorporation of Greek letter omega (W)-shape design feature into the rigid printed circuit board significantly increased (~14x) its flexibility as can be appreciated by reference to Table I in which board strength decreased while displacement increased for those boards having Greek letter omega (W)-shape design features versus control samples without any design features. This shape excelled at distributing tension and compression (delocalizing the stress) in the rigid printed circuit board.

Warpage analysis was conducted by computer simulation for printed circuit boards with various design features. Briefly, AUTODESK MOLDFLOW was utilized to run the computer simulation. The software program simulated a plastic polymer flowing into an injection molding tool. The FR4 board properties and the plastic polymer were the same for all of the simulation work. The plastic polymer was an unfilled polycarbonate resin. The FR4 board properties were researched and found on the internet. As can be appreciated by reference to Table II below, the Greek letter omega (W)-shape design feature showed the least amount of warpage.

**Table II**

| **Design feature shape** | **Warpage (out of plane) mm** |
|---|---|
| Flat | 19.67 |
| Omega (W) | 2.25 |
| U-shape | 3.49 |
| Zigzag | 6.40 |

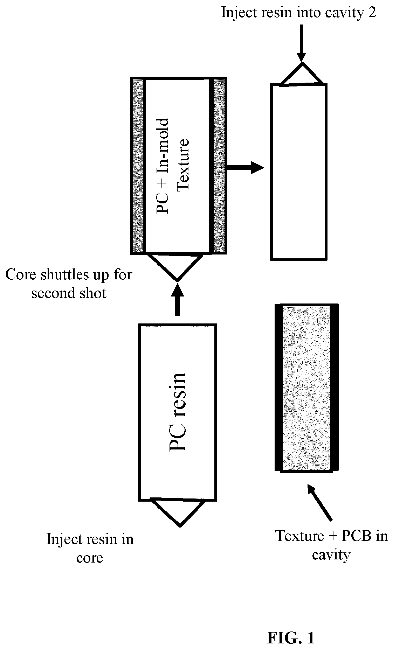

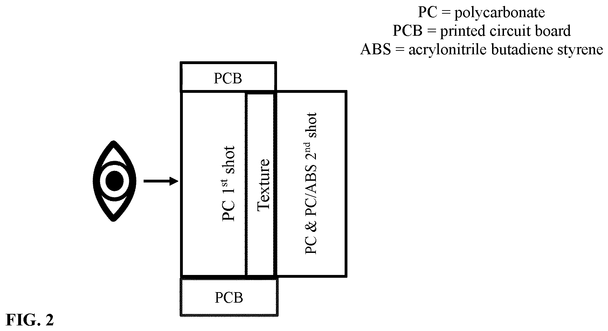

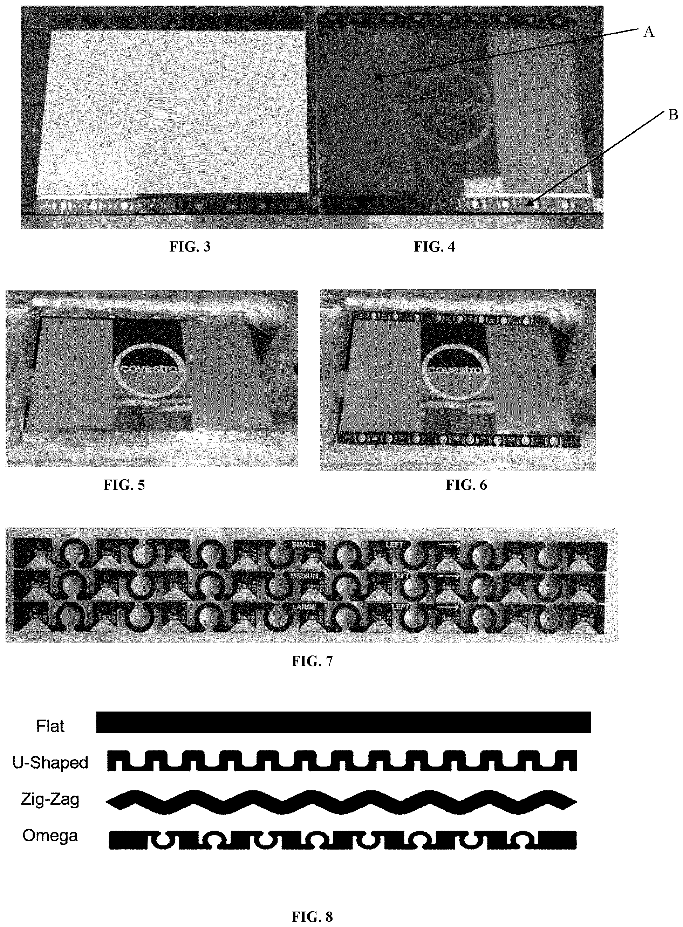

FIG. 1 provides a step-by-step diagram of the process to produce the printed circuit board according to the present invention and FIG. 2 depicts the final stack-up. FIG. 3 and FIG. 4 illustrate the first and second shots of the process according to the invention. FIG. 5 shows the first shot and the printed circuit board with two different textures, A and B. FIG. 6 depicts the printed circuit board of FIG. 4 with Greek letter omega (W)-shape design features on opposite edges of the board.

FIG. 7 is a photograph showing the Greek letter omega (W)-shapes arranged in alternating inverted and non-inverted orientations overmolded along opposite edges of the printed circuit board of the invention. These two-dimensional design shapes may provide adhesion to the thermoplastic resin along with imparting flexibility to the board while greatly reducing or even eliminating warpage of the board.

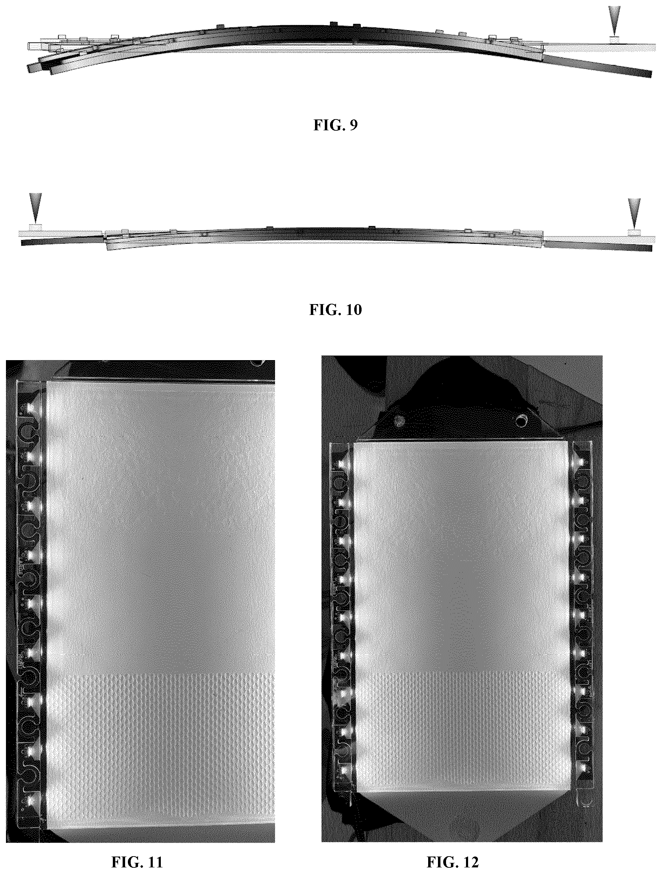

FIG. 8 depicts some possible two-dimensional shapes of design features including U-shapes, zigzag-shapes, and omega-shapes. FIG. 9 shows the stiffness of the board, high warpage with the first shot only. FIG. 10 illustrates how the overmolding of the second shot decreases the warpage, however, there is still a slight bow in the plaque.

FIG. 11 depicts an overmolded prototype printed circuit board with two different textures and a row of LEDs along the edge of the board where the Greek letter omega (W)-shape design features have been added by overmolding.

FIG. 12 illustrates an overmolded prototype with two different textures and a row of LEDs and a row of Greek letter omega (W)-shape design features along opposite edges of the printed circuit board.

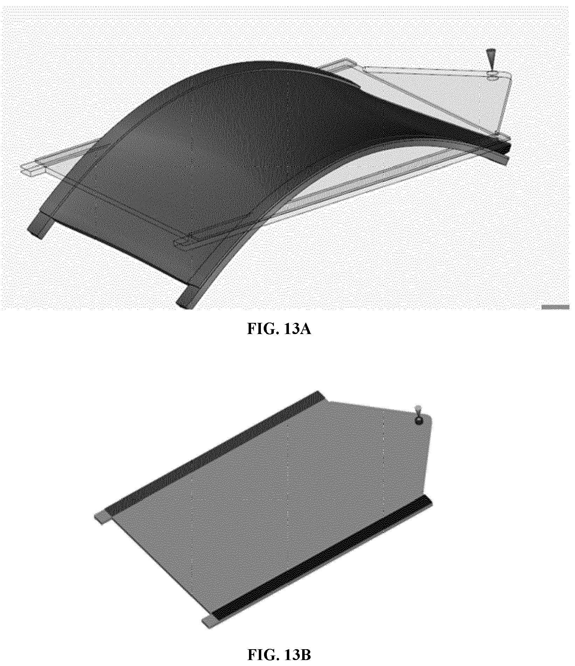

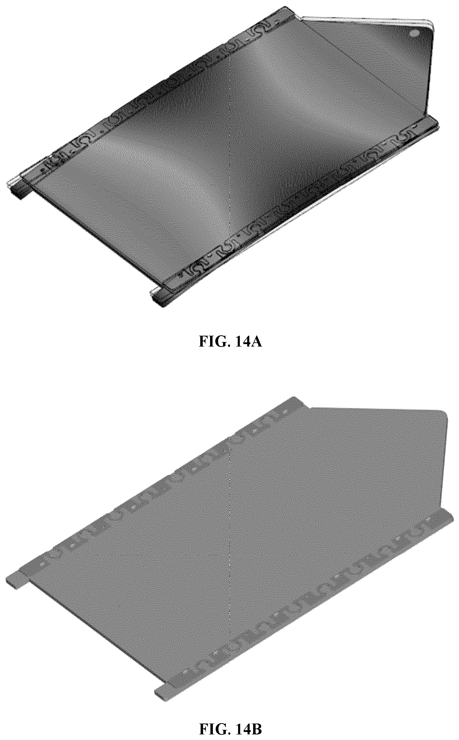

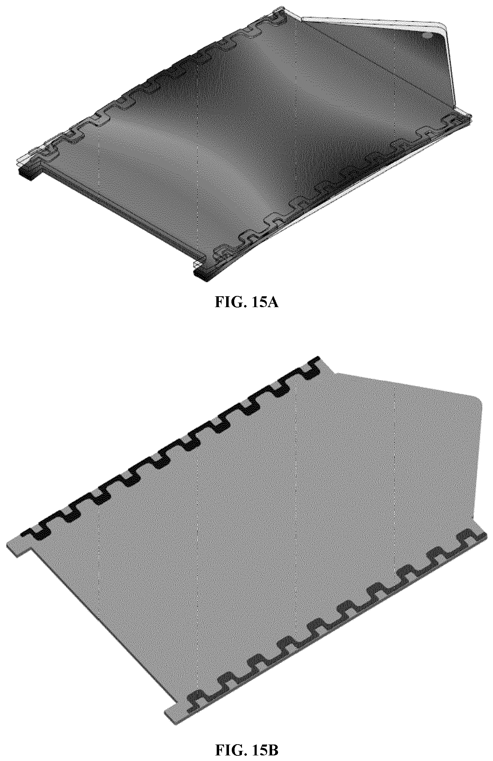

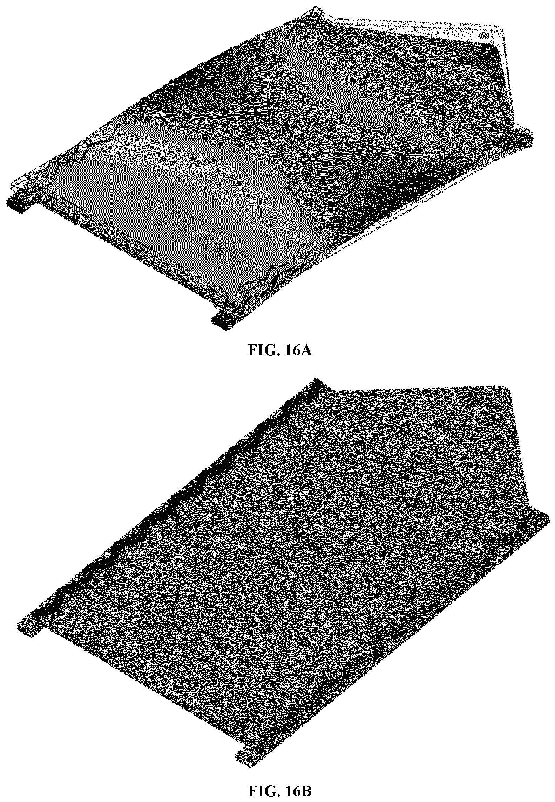

FIG. 13A and FIG. 13B show warpage analysis for a standard FR4 printed circuit board with no design features. FIG. 14A and FIG. 14B illustrate warpage analysis for Greek letter omega (W)-shape design feature printed circuit board with no pretension. FIG. 15A and FIG. 15B depict warpage analysis for U-shape design feature printed circuit board with no pretension. FIG. 16A and FIG. 16B shows warpage analysis for a zigzag shape design feature printed circuit board with no pretension.

This specification has been written with reference to various non-limiting and non-exhaustive embodiments. However, it will be recognized by persons having ordinary skill in the art that various substitutions, modifications, or combinations of any of the disclosed embodiments (or portions thereof) may be made within the scope of this specification. Thus, it is contemplated and understood that this specification supports additional embodiments not expressly set forth herein. Such embodiments may be obtained, for example, by combining, modifying, or reorganizing any of the disclosed steps, components, elements, features, aspects, characteristics, limitations, and the like, of the various non-limiting embodiments described in this specification. In this manner, Applicant reserves the right to amend the claims during prosecution to add features as variously described in this specification, and such amendments comply with the requirements of 35 U.S.C. §112(a), and 35 U.S.C. §132(a).

Various aspects of the subject matter described herein are set out in the following paragraphs:
In a first aspect, the present invention is directed to a flexible printed circuit board (PCB) comprising: a rigid printed circuit board with a first edge having a first strip of design features overmolded thereon and a second edge located opposite the first edge and having a second strip of design features overmolded thereon, wherein the design features of the first strip and the design features of the second strip each independently comprise a two-dimensional shape selected from the group consisting of U-shapes, zigzag shapes, and Greek letter omega (W)-shapes, and wherein the rigid printed circuit board has one or more vias therein.

**In** a second aspect, the present invention is directed to the flexible printed circuit board according to the previous paragraph, wherein the first strip of design features comprises Greek letter omega (W)-shapes arranged in alternating inverted and non-inverted orientations.

**In** a third aspect, the present invention is directed to the flexible printed circuit board according to one of the two previous paragraphs, wherein the second strip of design features comprises Greek letter omega (W)-shapes arranged in alternating inverted and non-inverted orientations.

In a fourth aspect, the present invention is directed to the flexible printed circuit board according to any one of the three previous paragraphs, wherein the first strip of design features and the second strip of design features each comprise a thermoplastic resin independently selected from the group consisting of polycarbonate, acrylonitrile-butadiene-styrene (ABS) copolymer, and combinations thereof.

In a fifth aspect, the present invention is directed to the flexible printed circuit board according to the previous paragraph, wherein the thermoplastic resin is clear or translucent in appearance.

In a sixth aspect, the present invention is directed to the flexible printed circuit board according to any one of the five previous paragraphs, wherein the design features impart flexibility to the rigid printed circuit board.

In a seventh aspect, the present invention is directed to the flexible printed circuit board according to any one of the six previous paragraphs, wherein the rigid printed circuit board comprises a substrate selected from the group consisting of metal core, polytetrafluoroethylene (TEFLON), paper (FR-1), phenolic cotton paper (FR-2), cotton paper and epoxy composite (FR-3), woven glass and epoxy (FR-4), woven glass and epoxy (FR-5), matte glass and polyester (FR-6), woven glass and epoxy (G-10), cotton paper and epoxy (CEM-1), cotton paper and epoxy (CEM-2), non-woven glass and epoxy (CEM-3), woven glass and epoxy (CEM-4), and woven glass and polyester (CEM-5).

In an eighth aspect, the present invention is directed to the flexible printed circuit board according to any one of the seven previous paragraphs, wherein the flexible printed circuit board has a displacement of at least five times greater than that of a comparable rigid printed circuit board without design features.

In a ninth aspect, the present invention is directed to the flexible printed circuit board according to any one of the eight previous paragraphs, wherein the flexible printed circuit board has a tensile strength of less than 10% that of a comparable rigid printed circuit board without design features.

In a tenth aspect, the present invention is directed to the flexible printed circuit board according to any one of the nine previous paragraphs, wherein the first strip of design features and the second strip of design features each comprise polycarbonate.

In an eleventh aspect, the present invention is directed to the flexible printed circuit board according to any one of the ten previous paragraphs further including a texture molded into the flexible printed circuit board.

In a twelfth aspect, the present invention is directed to the electronic device comprising the flexible printed circuit board according to any one of the eleven previous paragraphs electrically connected to a component selected from the group consisting of light emitting diodes (LEDs), transistors, resistors, constant current drivers, drivers/controllers, microcontrollers, capacitors, microprocessors, integrated circuits, photocells, piezo-transducers, inductors, and proximity switches.

In a thirteenth aspect, the present invention is directed to the electronic device according to the previous paragraph, wherein the component is a light emitting diode (LED).

## Claims

1. A flexible printed circuit board (PCB) comprising:
a rigid printed circuit board with a first edge having a first strip of design features overmolded thereon and a second edge located opposite the first edge and having a second strip of design features overmolded thereon,
wherein the design features of the first strip and the design features of the second strip each independently comprise a two-dimensional shape selected from the group consisting of U-shapes,
zigzag shapes, and Greek letter omega (W)-shapes, and
wherein the rigid printed circuit board has one or more vias therein.

2. The flexible printed circuit board according to claim 1, wherein the first strip of design features comprises Greek letter omega (W)-shapes arranged in alternating inverted and non-inverted orientations.

3. The flexible printed circuit board according to one of claims 1 and 2, wherein the second strip of design features comprises Greek letter omega (W)-shapes arranged in alternating inverted and non-inverted orientations.

4. The flexible printed circuit board according to any one of claims 1 to 3, wherein the first strip of design features and the second strip of design features each comprise a thermoplastic resin independently selected from the group consisting of polycarbonate, acrylonitrile-butadiene-styrene (ABS) copolymer, and combinations thereof.

5. The flexible printed circuit board according to claim 4, wherein the thermoplastic resin is clear or translucent in appearance.

6. The flexible printed circuit board according to any one of claims 1 to 5, wherein the design features impart flexibility to the rigid printed circuit board.

7. The flexible printed circuit board according to any one of claims 1 to 6, wherein the rigid printed circuit board comprises a substrate selected from the group consisting of metal core, polytetrafluoroethylene (TEFLON), paper (FR-1), phenolic cotton paper (FR-2), cotton paper and epoxy composite (FR-3), woven glass and epoxy (FR-4), woven glass and epoxy (FR-5), matte glass and polyester (FR-6), woven glass and epoxy (G-10), cotton paper and epoxy (CEM-1), cotton paper and epoxy (CEM-2), non-woven glass and epoxy (CEM-3), woven glass and epoxy (CEM-4), and woven glass and polyester (CEM-5).

8. The flexible printed circuit board according to any one of claims 1 to 7, wherein the flexible printed circuit board has a displacement of at least five times greater than that of a comparable rigid printed circuit board without design features.

9. The flexible printed circuit board according to any one of claims 1 to 8, wherein the flexible printed circuit board has a tensile strength of less than 10% that of a comparable rigid printed circuit board without design features.

10. The flexible printed circuit board according to any one of claims 1 to 9, wherein the first strip of design features and the second strip of design features each comprise polycarbonate.

11. The flexible printed circuit board according to any one of claims 1 to 10 further including a texture molded into the flexible printed circuit board.

12. An electronic device comprising the flexible printed circuit board according to any one of claims 1 to 11 electrically connected to a component selected from the group consisting of light emitting diodes (LEDs), transistors, resistors, constant current drivers, drivers/controllers, microcontrollers, capacitors, microprocessors, integrated circuits, photocells, piezo-transducers, inductors, and proximity switches.

13. The electronic device according to claim 12, wherein the component is a light emitting diode (LED).
